## Europäisches Patentamt
## European Patent Office
## Office européen des brevets

(11) Publication number: **0 165 570**
**B1**

(12)

# EUROPEAN PATENT SPECIFICATION

(45) Date of publication of patent specification: **30.01.91**

(21) Application number: **85107371.8**

(22) Date of filing: **14.06.85**

(51) Int. Cl.⁵: **H 01 L 31/0224,**
**H 01 L 31/18, H 01 L 31/06**

(54) Heat-resistant thin film photoelectric converter.

(30) Priority: **15.06.84 JP 124331/84**
**16.07.84 JP 148411/84**
**11.10.84 JP 213943/84**
**18.12.84 JP 267256/84**

(43) Date of publication of application:
**27.12.85 Bulletin 85/52**

(45) Publication of the grant of the patent:
**30.01.91 Bulletin 91/05**

(84) Designated Contracting States:
**BE CH DE FR GB IT LI NL SE**

(56) References cited:
**US-A-3 965 279**
**US-A-3 968 272**
**US-A-4 180 596**
**US-A-4 278 704**

**IBM TECHNICAL DISCLOSURE BULLETIN, vol. 19, no. 9, February 1977, page 3382, New York, US; P.L. GARBARINO et al.: "Contact barrier metallurgy for MOSFET gate"**

(73) Proprietor: **KANEGAFUCHI KAGAKU KOGYO KABUSHIKI KAISHA**
**2-4 Nakanoshima 3-chome**
**Kita-ku Osaka-shi Osaka-fu (JP)**

(72) Inventor: **Takada, Jun**
**29-204, Karikuchidai 4 Tarumi-ku**
**Kobe-shi Hyogo-ken (JP)**
Inventor: **Yamaguchi, Minori**
**5-40, Higashihitomaru-cho**
**Akashi-shi Hyogo-ken (JP)**
Inventor: **Tawada, Yoshihisa**
**14-39, Miyamadai Oike Kita-ku**
**Kobe-shi Hyogo-ken (JP)**

(74) Representative: **Türk, Gille, Hrabal**
**Brucknerstrasse 20**
**D-4000 Düsseldorf 13 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

(56) References cited:

THIN SOLID FILMS, vol. 104, no. 1/2, June 1983, pages 197-206, Elsevier Sequoia, Lausanne, CH, printed in the Netherlands; S.R. HERD et al.: "Formation and crystallization of amorphous silicides at the interface between thin metal and amorphous silicon films"

IBM TECHNICAL DISCLOSURE BULLETIN, vol. 25, no. 2, July 1982, pages 601,602; H.J. TSAI: "Contact metallurgical process with laser beam annealing"

## Description

The present invention relates to a heat-resistant thin film photoelectric converter and the preparation thereof.

A thin film photoelectric converter is used for a solar cell, photo-detector, photo-receptor for electrophotography, laser, electro-luminescent device, or the like. A thin film photoelectric converter includes fundamentally a layer of semiconductor and electrodes which come in contact with the layer of semiconductor. As an electrode, a transparent electrode or a metal electrode is used. For a material of transparent electrode, there hitherto has been used a metallic compound such as ITO, ITO/SnO$_2$, SnO$_2$, In$_2$O$_3$, Cd$_x$SnO$_y$ (x = 0.5 to 2, y = 2 to 4), Ir$_2$O$_{1-z}$ (z = 0.33 to 0.5), or the like. As a metal electrode, a metal such as Al, stainless steel, Fe, Ni, Cu, Brass, Zn, Ag, or the like is provided on the semiconductor.

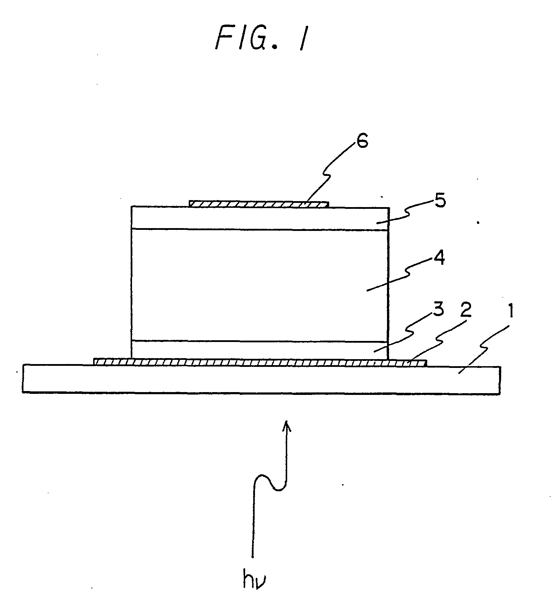

In Fig. 1, as an example of photoelectric converter, a typical structure of a solar cell is illustrated [compare US—A—4,064,521]. A solar cell has, as shown in Fig. 1, a transparent electrode 2 of a metallic compound (e.g. a metal oxide) on a transparent substrate 1 (e.g. a glass), and thereon, a layer of p-type semiconductor 3, a layer of i-type semiconductor 4, and a layer of n-type semiconductor 5 are provided. On the layer of n-type semiconductor 5, a layer of metal electrode 6 is provided as a backing electrode. Light comes into a semiconductor layer through a transparent electrode and is absorbed in the semiconductor so as to generate an electric power. A part of light which is not absorbed in the semiconductor reaches to the backing electrode and is reflected to be absorbed in the semiconductor layer again.

When a conventional solar cell is used at a temperature above about 50°C, a metal such as Al, Cu, brass, zinc or Ag, or metallic compound in the electrode is diffused to the semiconductor layer, so that the quality of the semiconductor is lowered. Especially, when an amorphous or microcrystalline semiconductor is used, the quality of the amorphous or microcrystalline semiconductor is notably lowered. For instance, in case that solar cells are used in the open air, the temperature at the surface of the solar cells reaches to about 80°C, so that the quality is remarkably lowered.

There are some metals which are not diffused to the semiconductor layer when used as an electrode. Examples of such metals are Cr, Ni, Fe or stainless steel. However, those metals have a low electric conductivity or a low reflectivity compared with the above-mentioned metals such as Al, Cu, brass, Zn and Ag. Thus, a solar cell having an electrode of Cr, Ni, Fe or stainless steel has a drawback because of its low quality due to ohmic loss in the electrode or reflection loss of light at the electrode. Any type of photoelectric converter, not only a solar cell, has a disadvantage as mentioned above when used at a high temperature.

In US—A—4 278 704 a photoelectric converter is disclosed which employs a layer of metal silicide as a front electrode which has the function of a mere electrode. Said layer of metal silicide has a thickness of about 1000 × 10$^{-10}$m.

In the IBM technical disclosure Bulletin, Vol. 19, No. 9, February 1977, page 3382 is disclosed that, in a MOSFET a silicide is used to prevent dissolution of a poly-Si layer by aluminium electrodes.

In the IBM technical disclosure Bulletin, Vol. 25, No. 2, July 1982, pages 601 to 602 the use of a metal silicide as a diffusion barrier in a semiconductor contact is disclosed.

An object of the present invention is to provide a heat-resistant thin film photoelectric converter, in order to avoid the fall-down of the quality owing to the diffusion of metal or metallic compound from the electrode to the semiconductor layer, in the condition that the ohmic loss in the backing electrode and the reflection loss of light at the backing electrode are not increased.

The present invention relates to a heat-resistant thin film photoelectric converter comprising a semiconductor layer (3, 4, 5), a front transparent electrode (2), a backing metal electrode (6), and a diffusion-blocking layer, said diffusion-blocking layer being provided between the semiconductor layer (3, 4, 5) and the backing metal electrode (6) and being a layer of metal silicide having a thickness in the range of 5 × 10$^{-10}$m to 100 × 10$^{-10}$m.

Fig. 1 is a schematic view of a conventional thin film photoelectric converter.

In a heat-resistant thin film photoelectric converter of the present invention, a diffusion-blocking layer is provided between a layer of semiconductor and a layer of electrode. In the invention, the layer can be provided on any side of the semiconductor.

Such a diffusion-blocking layer prevents diffusion of metal or metallic compound used as the electrode to a layer of semiconductor. The component of the diffusion-blocking layer is optionally selected as far as it has some conductivity and prevents the diffusion of metal or metallic compound to a layer of semiconductor. Examples of such components are a metal silicide, a silicide-formable metal, and a metal of the Groups IVA and VA of the periodic Table.

Examples of metal silicides used for a diffusion-blocking layer are silicides of metals of the Groups IA, IIA (excepting Be), IIIB, IVB, VB, VIB, VIIB (excepting Tc) and VIII of the Periodic Table. Specific examples of metal silicides are strontium silicide, barium silicide, titanium silicide, zirconium silicide, hafnium silicide, vanadium silicide, niobium silicide, tantalum silicide, chromium silicide, molybdenum silicide, tungsten silicide, manganese silicide, rhenium silicide, iron silicide, ruthenium silicide, osmium silicide, cobalt silicide, iridium silicide, nickel silicide, and platinum silicide. Among those silicides, a silicide of Group VIB metal of the Periodic Table or a silicide of metal alloy containing more than 50 atomic % of Group VIB metal is preferable, since the material does not cost and the layer is easily formed on the semiconductor.

Especially, chromium silicide or silicide of metal alloy containing more than 50 atomic % of chromium is preferable. A content of metal in the metal silicide is 1 atomic % to 90 atomic %, preferably 1 atomic % to 50 atomic %. When the content of metal is less than 1 atomic %, the thermal diffusion of the metal or the metal compound of the electrode cannot be prevented. When the content of metal is over 90 atomic %, a transparency of the layer becomes poor, so that the impinging light or the reflected light from the backing electrode cannot be fully utilized. The absorption coefficient of metal silicide is preferably $10^6 cm^{-1}$ to $10^4 cm^{-1}$ for a wavelength of 400 nm to 700 nm.

Another material that can be used for the diffusion-blocking layer is a silicide-formable metal. Such a metal reacts with silicon atoms in the semiconductor layer, and forms a thin layer of metal silicide, whereby a diffusion of metal or metallic compound is prevented. The silicide-formable metals are metals of the Groups IA, IIA (excepting Be), IIIB, IVB, VB, VIB, VIIB (excepting Tc) and VIII of the Periodic Table. Specific examples of silicide-formable metals are Sr, Ba, Ti, Zr, Hf, V, Bnb, Ta, Cr, Mo, W, Mn, Re, Fe, Ru, Os, Co, Ir, Ni and Pt. A metal of the Group VIB is preferable since the material does not cost and the layer is easily formed on the semiconductor. Especially, chromium or metal alloy containing more than 50% of chromium is preferable.

The other materials that form diffusion-blocking layer are metals of the Groups IVA and VA of the Periodic Table. Such metals also prevent diffusion of metal of the electrode. Specific examples of those metals are Sn, Pb, Sb and Bi.

In the present invention, the thickness of the diffusion-blocking layer is $5 \times 10^{-10}$ m to $100 \times 10^{-10}$ m (5 Å to 100 Å).

When the thickness is below $5 \times 10^{-10}$ m (5 Å), an uniform and homogeneous layer cannot be obtained and the diffusion of the metal of the electrode to the semiconductor cannot be fully prevented. When the thickness is above $1 \times 10^{-7}$ m (1000 Å), a series electric resistance of the layer is increased, a reflectivity at the backing electrode is decreased and much time for depositing the layer is required.

A thickness of the diffusion-blocking layer can be measured by using a crystal sensor, or decided from surface analysis by means of SIMS (Secondary Ion Mass Spectroscopy).

The semiconductor in the invention is preferably to be amorphous or microcrystalline semiconductor, because the fall-down of the characteristics of the amorphous or microcrystalline semiconductor at a high temperature is remarkably improved.

The semiconductor layer of the thickness of 0.02 to 100 μm can be used in the present invention.

With respect to a composition of the semiconductor, silicon or silicon alloy containing hydrogen, fluorine, carbon, nitrogen, oxygen, germanium or tin is preferably used. Specific examples of such semiconductors are as follows: a-Si:H, a-Si:F:H, a-SiGe:H, a-SiSn:H, a-SiN:H, a-SiGe:F:H, a-SiSn:F:H, a-Si:N:F:H, a-SiC:H, a-SiC:F:H, a-SiO:H, a-SiO:F:H, μc-Si:H, and μc-Si:F:H, wherein, a- indicates amorphous and μc- indicates microcrystalline.

In the present invention, a semiconductor of p-i-n, p-n or Schottky type can be used. For a semiconductor which comes to contact with the diffusion-blocking layer, n-type is preferable because the improvement of the characteristics in the invention is notable.

The electrode is placed on an incident side (transparent side) of light and/or the other side (backing side).

The electrode on the incident side of light is transparent and is made of a metallic compound such as ITO (film of $In_2O_3$ containing $SnO_2$), $ITO/SnO_2$, $SnO_2$, $In_2O_3$, $Cd_xSnO_y$ (x = 0.5 to 2, y = 2 to 4), $Ir_zO_{1-z}$ (z = 0.33 to 0.5), or the Ike, but the other materials can be used.

The electrode provided on the backing side is a backing electrode made of metal or alloy of metals. Any metal or alloy is possibly used as far as it is usually used as a material of a backing electrode. For instance, Al, Ag, Au, Cu, brass, Zn, or the like is used as a backing electrode. Except those metals, any metal or alloy having the same physico-chemical properties can be used. However, a material which forms silicide such as Li, Na, Ka, Rb, Cs, Mg, Ca, Sr, Ba, Sc, Y, La, Ti, Zr, Hf, V, Nb, Ta, Cr, Mo, W, Mn, Re, Fe, Ru, Os, Co, Rh, Ir, Ni, Pd or Pt is less suitable as a material of the electrode since such a metal has a low electric conductivity and low reflectivity [compare "Binary Alloy Phase Diagrams" volume 2, American Society for Metals, Metals Park, Ohio 44073]. And a thickness of the diffusion-blocking layer cannot be controlled precisely due to the formation of silicide by the reaction of the metal of the electrode and the silicon of the semiconductor.

For a backing electrode, a metal having an electric conductivity of $0.1 \times 10^5$ to $6.2 \times 10^5$ $\Omega^{-1}$ $cm^{-1}$ can be used. The electric conductivity is preferably above $1.5 \times 10^5$ $\Omega^{-1}$ $cm^{-1}$, and especially, above $3.0 \times 10^5$ $\Omega^{-1}$ $cm^{-1}$ because the ohmic loss in the electrode is so small.

Another point of selecting a material for a backing electrode is its reflectivity of light. A metal having a reflectivity more than 20% to 99% for a light of wavelength of 700 nm can be used. A metal having a reflectivity of more than 50% to 99% for a light of wavelength of 700 nm is preferable. Example of such metal is Ag, Au, Al or Cu. A reflectivity in the present invention is defined as a reflectivity at a interface between a layer of hydrogenated amorphous silicon (a-Si:H) and an electrode. The reflectivity $R_{max}$ is given in the following formula:

4

$$R_{max} = \frac{(n_1 - n_2)^2 + k_2^2}{(n_1 + n_2)^2 + k_2^2}$$

wherein, $n_1$ is real part of a complex reflective index of hydrogenated amorphous silicon, $n_2$ and $k_2$ are real and imaginary parts of a complex reflective index of the metal, respectively.

Metals which satisfy the above condition are Ag, Au, Al, Cu and Zn. Among those metals, Ag, Au and Cu are preferable for the backing electrode.

Besides, both of monolayer type and multilayer type of the backing electrode can be used. In the multilayer type, the layer which directly comes to contact with the diffusion-blocking layer in the invention should possess high reflectivity and high conductivity so that the light is fully reflected on the contact surface and the series resistance of the interface is not increased.

The preparation of a heat-resistant thin film photoelectric converter in the present invention is explained as follows:

The semiconductor is assumed, for example, to be a p-i-n type semiconductor as is used for solar cells. The surface of the p-type semiconductor faces to a light-incident window. The whole thickness of the semiconductor in the photoelectric converter in the invention is 0.02 μm to 100 μm.

In the present invention, not only the p-i-n type semiconductor as mentioned above, but also a Schottky type or a p-n type semiconductor can be used. For solar cells, either hetero-junction type or homo-junction type can be used.

The amorphous p-i-n type semiconductor film is deposited on a transparent electrode which is provided on a transparent substrate. A p-layer comes in contact with the transparent electrode.

The diffusion-blocking layer in the invention is deposited by means of electron-beam-evaporation onto the amorphous p-i-n semiconductor film. Alternatively the sputtering method can also be employed.

The material to be deposited on the semiconductor is a metal silicide, a silicide-formable metal or a metal selected from the Groups IVA and VA of the Periodic Table.

In case that a metal silicide is employed as a depositing member, the layer of metal silicide is formed by depositing a metal silicide compound by means of electron-beam-evaporation or sputtering. However, the other method can also be employed wherein a metal is deposited by the use of a sputtering target and simultaneously silicon is deposited by glow-discharge decomposition. Co-sputtering process can also be employed for the deposition of the layer, wherein sputtering of metal and sputtering of silicon are carried out simultaneously.

The preparation of metal silicide is also performed by depositing only silicide-formable metal on the semiconductor layer, and then annealing the deposited layer for 0.5 to 4 hours at 80°C to 400°C. A reaction of the metal with silicon in the semiconductor takes place to form metal silicide. If necessary, the residual metal layer is etched. In the method, a metal silicide layer of 5 Å to 300 Å $(1 \text{ Å} = 1 \times 10^{-10}\text{m})$ thickness is obtained. The content of the metal in the layer is 2 atomic % to 20 atomic %. The annealing method for preparing metal silicide is preferable since it is easy to fabricate the converter.

In case that a silicide-formable metal or a metal of the Groups IVA and VA is deposited, the electron-beam-evaporation or sputtering can also be employed.

After depsoiting the diffusion-blocking layer of the invention, a backing electrode is deposited on the layer.

The heat-resistant thin film photoelectric converter prepared by the above-described process has an advantage that its conversion efficiency is not lowered by heating. Besides, by annealing the converter at a temperature of 80°C to 400°C for 0.5 to 4 hours, the diffusion-blocking layer comes in contact more closely with the semiconductor and the electrode, so that the series resistance on the interface decreases.

The heat-resistant thin film photoelectric converter in the present invention can be preferably utilized as solar cells or photo-detector, since the ambient temperature of solar cells or photo-detector often becomes more than 50°C. Especially, with respect to solar cells, the ambient temperature reaches to about 80°C in the open air, so that the advantage of the photoelectric detector of the present invention is emphasized.

In addition, the advantage of the invention is that the reflection loss at the backing electrode for the longer wavelength of light is very small because the diffusion-blocking layer is comparatively thin.

A heat-resistant thin film photoelectric converter of the present invention and its preparation are exemplified by the following Examples.

## Example 1

On the glass substrate of 1 mm thick, the transparent $ITO/SnO_2$ electrode of 1,000 Å was provided.

The amorphous p-layer of 120 Å, i-layer of 5,000 Å and n-layer of 500 Å were successively deposited by means of glow-discharge decomposition. In the depositing process of p-type semiconductor, the mixed gas composed of $SiH_4$ and $B_2H_6$ was used at a temperature of 200°C of the substrate and under a pressure of about 1 Torr. The mixed gas of $SiH_4$ and $H_2$, and the mixed gas of $SiH_4$ and $PH_3$ were used for depositing i-type and n-type semiconductors, respectively. The depositing conditions were the same as the conditions for depositing p-type semiconductor.

Then chromium was deposited by means of electron-beam-evaporation under a pressure of $10^{-6}$ Torr (1 torr = 1,32 mbar) on the n-layer of the semiconductor. The thickness of the chromium layer was 100 Å. Thereon aluminum was deposited in 1000 Å thick, and thereafter solar cell was annealed for 1.5 hours at 150°C.

The characteristics of the solar cell formed by the above-described porocess were measured by a solar simulator under a condition of AM-1, 100 mW/cm². The characteristics were again measured after heating the cell at 230°C for 2 hours. The results are shown in Table 1.

## Example 2

The solar cell was prepared in the same condition as in Example 1 but it was not annealed. The characteristics were measured, and after heating the cell at 230°C for 2 hours, the characteristics were again measured. The result is shown in Table 1.

## Example 3

In the same manner as in Example 1, chromium was deposited in 100 Å thick and annealed at 210°C for 2 hours. Thereafter the residual chromium was etched and then the aluminum was deposited till the thickness of 1000 Å. The solar cell was again annealed at 200°C for 2 hours. The Cr-Si layer of 100 Å included 10 atomic % of chromium.

The solar cell was heated for 2 hours at 230°C. Before and after heating, the solar cell was measured as in Example 1, respectively. The results are shown in Table 1.

## Example 4

The solar cell was prepared in the same manner as in Example 3 except that it was not annealed at 200°C for 2 hours. The obtained solar cell was measured before and after heating at 230°C for 2 hours. The results are shown in Table 1.

## Example 5

The solar cell was prepared in the same manner as in Example 3 except that the thickness of the n-layer was 300 Å and the chromium was deposited in 20 Å and silver was deposited in 1000 Å as a backing electrode. The obtained solar cell was annealed at 200°C for 2 hours. The results before and after heating at 230°C for 6 hours are shown in Table 1.

## Example 6

The solar cell was prepared in the same manner as in Example 5, but it was not annealed at 200°C for 2 hours. The characteristics of the obtained solar cell were measured. The results are shown in Table 1.

## Examples 7 to 18

On the glass substrate of 1.1 mm thick, the transparent $ITO/SnO_2$ electrode of 850 Å was provided.

The amorphous P-layer of 100 Å, i-layer of 500 Å and microcrystalline n-layer of 500 Å were deposited, respectively, by glow-discharge decomposition. The p-layer was deposited under a mixed gas of $SiH_4$, $CH_4$, $B_2H_6$ and $H_2$, the i-layer was deposited under a gas of $SiH_4$ and the n-layer was deposited under a mixed gas of $SiH_4$, $PH_3$ and $H_2$. The pressure of the gas was about 1 Torr, and the temperature of the substrate was 200°C.

Thereon, V and Ti were deposited by means of electron-beam-evaporation, respectively, under 5 × $10^{-6}$ Torr on the microcrystalline n-layer. The deposited layers were of 30 Å, 50 Å, 100 Å, 300 Å, 500 Å and 1000 Å for each metal. Thereon an aluminum electrode of 2000 Å was deposited.

Those twelve solar cells were heated for 4 hours at 230°C, and the characteristics were measured in the same manner as in Example 1.

The conversion efficiencies after heating were decreased for every solar cell. However, the efficiencies were not decreased to less than 85% of their initial values.

## Examples 19 to 30

Instead of V and Ti, Sb and Sn were deposited, respectively, in the same manner as in Examples 7 to 18, and twelve solar cells were obtained. Those solar cells were heated for 4 hours at 230°C, and the characteristics were measured in the same manner as in Example 1.

The conversion efficiencies after heating were decreased for every solar cell. However, the efficiencies were not decreased to less than 85% of their initial values.

## Comparative Example 1

The solar cell was prepared in the same manner as in Example 1 but the diffusion-blocking layer was not provided. The characteristics before and after heating at 230°C for 2 hours were measured in the same manner as in Example 1. The results are shown in Table 1.

### Comparative Example 2

The solar cell was prepared in the same manner as in Example 5 except that the diffusion-blocking layer was not provided. The characteristics before and after heating at 230°C for 6 hours were measured in the same manner as in Example 30. The results are shown in Table 1.

### Comparative Example 3

The solar cell wherein an aluminum backing electrode was replaced by a chromium backing electrode was prepared as in Comparative Example 1.

The characteristics before and after heating at 230°C for 2 hours are shown in Table 1.

### Comparative Example 4

A diffusion-blocking layer was not provided in the solar cell which was prepared in the same process as in Example 7. Characteristics of the fabricated solar cell was measured before and after heating at 230°C for 4 hours. The value of conversion efficiency after heating was decreased to 10% of its initial value.

Table 1

| | Chracteristics of solar cell before heating | | | | Chracteristics of solar cell after heating | | | | Heating condition | |
|---|---|---|---|---|---|---|---|---|---|---|
| | Short circuit current density | Open circuit Voltage | Fill factor | Coversion efficiency | | | | | | |
| | Jsc | Voc | FF | η | Jsc | Voc | FF | η | °C | hours |
| Ex. 1 | 0.98 | 0.98 | 0.99 | 0.95 | 0.89 | 0.98 | 0.99 | 0.79 | 230 | 2 |
| " 2 | 0.96 | 0.96 | 0.90 | 0.83 | 0.82 | 0.98 | 0.99 | 0.80 | 230 | 2 |
| " 3 | 1.00 | 1.00 | 1.00 | 1.00 | 0.91 | 1.00 | 1.00 | 0.91 | 230 | 2 |
| " 4 | 0.96 | 0.96 | 0.90 | 0.83 | 0.82 | 0.98 | 0.99 | 0.80 | 230 | 2 |
| Com Ex. 1 | 1.00 | 1.00 | 1.00 | 1.00 | 0.48 | 0.30 | 0.64 | 0.09 | 230 | 2 |
| " 3 | 0.85 | 0.98 | 0.93 | 0.77 | 0.72 | 0.98 | 0.93 | 0.66 | 230 | 2 |
| Ex. 5 | 1.00 | 1.00 | 1.00 | 1.00 | 0.97 | 1.00 | 1.00 | 0.97 | 230 | 6 |
| " 6 | 0.79 | 0.96 | 0.90 | 0.68 | – | – | – | – | – | – |
| Com Ex. 2 | 1.00 | 1.00 | 1.00 | 1.00 | 0.67 | 0.97 | 0.64 | 0.42 | 230 | 6 |

(Note) Values of Examples 1 to 4 and Comparative Example 3 are relative to the values as 1.00 for solar cell before heating in Comparative Example 1.
Values of Examples 5 and 6 are relative to the values regarded as 1.00 for solar cell before heating in Comparaive Example 2.

## Claims

1. A heat-resistant thin film photoelectric converter comprising a semiconductor layer (3, 4, 5), a front transparent electrode (2), a backing metal electrode (6), and a diffusion-blocking layer, said diffusion-blocking being provided between the semiconductor layer (3, 4, 5) and the backing metal electrode (6) and being a layer of metal silicide having a thickness in the range of $5 \times 10^{-10}$m to $100 \times 10^{-10}$m.

2. The converter of Claim 1, wherein the thickness of the diffusion-blocking layer of metal silicide is $7 \times 10^{-10}$m to $100 \times 10^{-10}$m.

3. The converter of Claim 1, wherein the metal silicide contains 1 atomic % to 90 atomic % of metal.

4. The converter of Claim 1, wherein the absorption coefficient of said metal silicide layer at a wavelength of 400 nm to 700 nm is $10^6$ to $10^4$/cm.

5. The converter of Claim 1, wherein the metal of the metal silicide is a metal of the Group VIB of the Periodic Table.

6. The converter of Claim 1, wherein the metal silicide is chromium silicide.

7. The converter of Claim 1, wherein the semiconductor (3, 4, 5) is at least one member selected from the group consisting of amorphous semiconductor and microcrystalline semiconductor.

8. The converter of Claim 7, wherein the semiconductor (3, 4, 5) is an alloy of silicon and at least one member selected from the group consisting of H, F, N, C, O, Ge and Sn.

9. The converter of Claim 1, wherein the metal of said backing metal electrode (6) has a conductivity of $0.1 \times 10^5$ to $6.2 \times 10^5$ $\Omega^{-1}$cm$^{-1}$ and optical reflectivity of 20% to 99%.

10. The converter of Claim 9, wherein the metal of said backing metal electrode (6) has the conductivity of $3.0 \times 10^5$ to $6.2 \times 10^5$ $\Omega^{-1}$cm$^{-1}$ and optical reflectivity of 50% to 99%.

11. A process for preparing a heat-resistant thin film photoelectric converter comprising a semiconductor layer (3, 4, 5), a front transparent electrode (2), a backing metal electrode (6), and a diffusion-blocking layer provided between the semiconductor layer and the backing metal electrode according to claim 1, characterized in forming a silicide formable metal between the semiconductor layer and the backing metal electrode, and annealing the fabricated converter for 0.5 to 4 hours at a temperature of 80°C to 400°C.

12. The process of Claim 11, wherein said diffusion-blocking layer is formed by deposition of a silicide-formable metal.

## Patentansprüche

1. Hitzebeständiger photoelektrischer Dünnschichtkonverter, umfassend eine Halbleiterschicht (3, 4, 5), eine vordere transparente Elektrode (2), eine rückwärtige Metallelektrode (6) und eine Diffusion-verhindernde Schicht, wobei die Diffusion-verhindernde Schicht zwischen der Halbleiterschicht (3, 4, 5) und der rückwärtigen Metallelektrode (6) angebracht ist und die eine Schicht aus Metallsilicid ist mit einer Dicke in dem Bereich von $5 \times 10^{-10}$m bis $100 \times 10^{-10}$m.

2. Konverter nach Anspruch 1, worin die Dicke der Diffusionverhindernden Schicht aus Metallsilicid $7 \times 10^{-10}$m bis $100 \times 10^{-10}$m ist.

3. Konverter nach Anspruch 1, worin das Metallsilicid 1 Atom-% bis 90 Atom-% Metall enthält.

4. Konverter nach Anspruch 1, worin der Absorptionskoeffizient der Metallsilicidschicht bei einer Wellenlänge von 400 nm bis 700 nm $10^6$ bis $10^4$/cm beträgt.

5. Konverter nach Anspruch 1, worin das Metall des Metallsilicids ein Metall aus der Gruppe VIB des Periodensystems ist.

6. Konverter nach Anspruch 1, worin das Metallsilicid Chromsilicid ist.

7. Konverter nach Anspruch 1, worin der Halbleiter (3, 4, 5) mindestens ein Mitglied ist, ausgewählt aus der Gruppe bestehend aus amorphem Halbleiter und mikrokrystallinem Halbleiter.

8. Konverter nach Anspruch 1, worin der Halbleiter (3, 4, 5) eine Legierung aus Silizium und mindestens einem Mitglied ausgewählt aus der Gruppe bestehend aus H, F, N, C, O, Ge und Sn ist.

9. Konverter nach Anspruch 1, worin das Metall der rückwärtigen Metallelektrode (6) eine Leitfähigkeit von $0,1 \times 10^5$ bis $6,2 \times 10^5$ $\Omega^{-1}$cm$^{-1}$ und optische Reflektion von 20% bis 99% aufweist.

10. Konverter nach Anspruch 9, worin das Metall der rückwärtigen Metallelektrode (6) die Leitfähigkeit von $3,0 \times 10^5$ bis $6,2 \times 10^5$ $\Omega^{-1}$cm$^{-1}$ und optische Reflektion von 50% bis 99% aufweist.

11. Verfahren zur Herstellung eines hitzebeständigen photoelektrischen Dünnschichtkonverters, umfasend eine Halbleiterschicht (3, 4, 5), eine vordere transparente Elektrode (2), eine rückwärtige Metallelektrode (6) und eine Diffusion-verhindernde Schicht, die zwischen der Halbleiterschicht und der rückwärtigen Metallelektrode nach Anspruch 1 angebracht ist, gekennzeichnet durch Bilden eines Silicid-bildenden Metalls zwischen der Halbleiterschicht und der rückwärtigen Metallelektrode und Glühen des hergestellten Konverters 0,5 bis 4 Stunden bei einer Temperatur von 80°C bis 400°C.

12. Verfahren nach Anspruch 11, worin die Diffusion-verhindernde Schicht gebildet wird durch Ablagern eines Silicid-bildenden Metalls.

# EP 0 165 570 B1

## Revendications

1. Convertisseur photoélectrique à couche mince résistant à la chaleur comprenant une couche semiconductrice (3, 4, 5), une électrode transparente frontale (2), une électrode métallique arrière (6), et une couche bloquant la diffusion, ladite couche bloquant la diffusion étant fournie entre la couche semi-conductrice (3, 4, 5) et l'électrode métallique de renforcement (6) et étant une couche de siliciure métallique ayant une épaisseur située dans un intervalle allant de $5 \times 10^{-10}$m à $100 \times 10^{-10}$m.

2. Convertisseur de la revendication 1, dans lequel l'épaisseur de la couche de siliciure métallique bloquant la diffusion est de $7 \times 10^{-10}$m à $100 \times 10^{-10}$m.

3. Convertisseur de la revendication 1, dans lequel le siliciure métallique contient de 1% atomique à 90% atomique de métal.

4. Convertisseur de la revendication 1, dans lequel le coefficient d'absorption de ladite couche de siliciure métallique à une longueur d'onde de 400 nm à 700 nm est de $10^6$ à $10^4$/cm.

5. Convertisseur de la revendication 1, dans lequel le métal du siliciure de métal est un métal du groupe VIB de la classification périodique des éléments.

6. Convertisseur de la revendication 1, dans lequel le siliciure métallique est le siliciure de chrome.

7. Convertisseur de la revendication 1, dans lequel le semi-conducteur (3, 4, 5) est au moins un membre choisi dans le groupe constitué par un semi-conducteur amorphe et un semi-conducteur microcristallin.

8. Convertisseur de la revendication 7, dans lequel le semi-conducteur (3, 4, 5) est un alliage de silicium et d'au moins un membre choisi dans le groupee constitué par H, F, N, C, O, Ge et Sn.

9. Convertisseur de la revendication 1, dans lequel le métal de ladite électrode métallique arrière (6) a une conductivité de $0,1 \times 10^5$ à $6,2 \times 10^5$ $\Omega^{-1}$cm$^{-1}$ et une réflectivité optique de 20% à 99%.

10. Convertisseur de la revendication 9, dans lequel le métal de ladite électrode métallique arrière (6) a une conductivité de $3,0 \times 10^5$ à $6,2 \times 10^5$ $\Omega^{-1}$cm$^{-1}$ et une réflectivité optique de 50% à 99%.

11. Procédé de préparation d'un convertisseur photoélectrique à couche mince résistant à la chaleur comprenant une couche semi-conductrice (3, 4, 5), une électrode transparente frontale (2), une électrode métallique arrière (6), et une couche de bloquage de la diffusion fournie entre la couche semi-conductrice et l'électrode métallique arrière selon la revendication 1, caractérisé en ce qu'on forme un métal formable au siliciure entre la couche semi-conductrice et l'électrode métallique arrière, et en ce qu'on recuit le convertisseur fabriqué pendant $\frac{1}{2}$ h à 4 h à une température de 80°C à 400°C.

12. Procédé de la revendication 11, dans lequel ladite couche bloquant la diffusion est formée par dépôt d'un métal formable au siliciure.

# FIG. 1